# FASCICULE DE BREVET EUROPEEN

(11) **EP 1 595 284 B1**
(45) Date de publication et mention de la délivrance du brevet: **08.08.2007**
(21) Numéro de dépôt: 04708363.9
(22) Date de dépôt: 05.02.2004
(51) Int. Cl.: H01L 21/68

(54) **SEMELLE DE COLLAGE ELECTROSTATIQUE AVEC ELECTRODE RADIOFREQUENCE ET MOYENS THERMOSTATIQUES INTEGRES**
ELEKTROSTATISCHE BOND-EINSPANNVORRICHTUNG MIT INTEGRIERTER HOCHFREQUENZELEKTRODE UND THERMOSTATISCHEN MITTELN
ELECTROSTATIC BONDING CHUCK WITH INTEGRATED RADIO FREQUENCY ELECTRODE AND THERMOSTATIC MEANS

(30) Priorité: 05.02.2003 FR 0301323
(43) Date de publication de la demande: 16.11.2005
(73) Titulaire: Semco Engineering S.A., 34196 Montpellier cedex 5 (FR)
(72) Inventeur: PELLEGRIN, Yvon, F-34000 Montpellier (FR)
(74) Mandataire: Ravina, Bernard
(86) Numéro de dépôt international: PCT/EP2004/050083
(87) Numéro de publication internationale: WO 2004/070829

(56) Documents cités:
- EP-A- 1 124 256
- WO-A-97/44891
- US-B2- 6 490 146

## Description

La présente invention concerne une semelle de maintien électrostatique avec électrode radiofréquence et moyens thermostatiques intégrés. Elle s'applique, en particulier mais non exclusivement, à la fabrication des composants électroniques.

Pour effectuer la métallisation de substrats de silicium pour fabriquer des composants électroniques, par exemple des transistors MOS (Metal Oxid Semiconductors pour semiconducteurs métal oxyde), on effectue un dépôt d'aluminium par PVD (Physical Vapor Deposition pour déposition physique en phase vapeur). La recherche de l'optimisation des performances électriques liées à la diminution progressive des tailles des composants, les problèmes de soudure des connexions et la réalisation de puits de connexion entraîne l'industrie vers l'utilisation de cuivre en remplacement de l'aluminium pour réaliser l'étape de métallisation. On observe que le dépôt de cuivre s'effectue principalement par une réaction d'électrodéposition en milieu liquide qui nécessite auparavant le dépôt d'une couche germinale de cuivre par PVD. Cette couche germinale a des caractéristiques extrêmement critiques. La présente invention, par ses propriétés spécifiques, participe a l'obtention de ces caractéristiques.

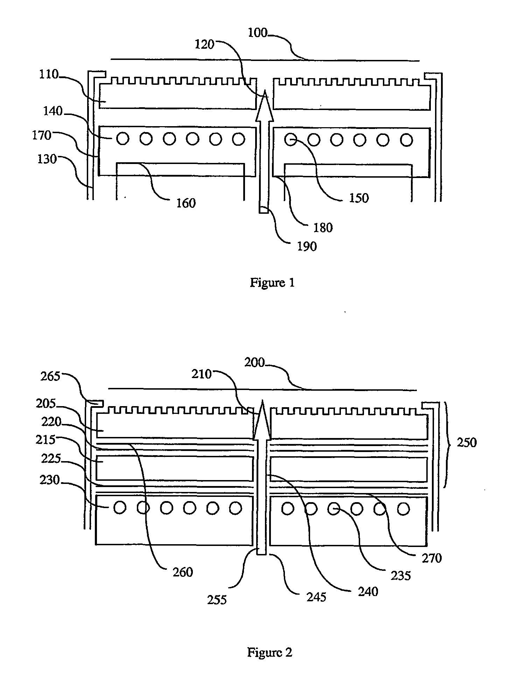

La figure 1 représente une semelle (en anglais "chuck") conforme à l'art antérieur. On y observe un substrat 100, par exemple une tranche de silicium (en anglais "wafer"), qui repose sur une semelle électrostatique 110 munie d'une ouverture centrale 120 et retenue latéralement par des crochets 130. La semelle 110 repose, elle-même, sur un support 140 (ou piédestal) comportant des circuits de refroidissement 150, des résistances de chauffage 160. La semelle possède une ouverture centrale 180, dans l'axe de l'ouverture centrale 120 de la semelle 110. Par ces ouvertures est injecté un gaz 190, par exemple de l'hélium ou de l'argon, favorisant les échanges thermiques entre le support 140, la semelle 110 et le substrat 100. Des éventuelles électrodes radiofréquences RF 170 sont placées sur le support 140.

La présence de deux séparations ("gaps") entre, d'une part, le substrat 100 et la semelle électrostatique 110 et, d'autre part, entre la semelle électrostatique 110 et le support 140 implique des problèmes de montée en température, de contrôle de température (chaque séparation provoque une différence de température de plusieurs dizaines de degrés) et d'uniformité de température sur la surface du substrat 100.

La présente invention vise à remédier à ces inconvénients.

A cet effet, la présente invention vise une semelle électrostatique caractérisée en ce qu'elle comporte:
- une céramique supérieure adaptée à porter le substrat à traiter,
- une céramique inférieure portant des éléments chauffants et des électrodes radiofréquence,
lesdites céramiques étant collées entre elles de manière durable.

Grâce à ces dispositions, une seule séparation est opérée, la régulation et l'uniformité de température sont plus aisées et plus sûres et les montées en température plus rapides. Les électrodes radiofréquences permettent de moduler le plasma autour du substrat à traiter.

Selon des caractéristiques particulières, les céramiques sont collées entre elles par du verre chauffé. Grâce à ces dispositions, le collage est isolant et très résistant et on peut réduire les contraintes et dispositions relatives à l'isolation des électrodes RF, le piédestal pouvant être mis à la terre.

Selon des caractéristiques particulières, la semelle électrostatique comporte un piédestal portant des éléments de refroidissement, la céramique inférieure étant assemblée au piédestal de manière durable.

Selon des caractéristiques particulières, la céramique inférieure est assemblée au piédestal par liaison brasée.

Selon des caractéristiques particulières, la brasure de la liaison brasée est à l'indium.

Selon des caractéristiques particulières, la céramique inférieure est assemblée au piédestal par collage.

Selon des caractéristiques particulières, le collage est à l'argent.

Grâce à chacune de ces dispositions, la céramique inférieure et le piédestal sont en bonne liaison thermique et les électrodes RF sont isolées du piédestal.

Selon des caractéristiques particulières, la céramique inférieure comporte des éléments de refroidissement.

Selon des caractéristiques particulières, la céramique inférieure est portée par des supports latéraux assemblés de manière durable à ladite céramique inférieure.

D'autres avantages, buts et caractéristiques ressortiront de la description qui va suivre, faite de manière explicative et nullement limitative en regard du dessin annexé dans lequel :
- la figure 1 représente schématiquement, en coupe, une semelle conforme à l'art antérieur,
- la figure 2 représente schématiquement, en coupe, un premier mode de réalisation d'une semelle électrostatique conforme à la présente invention,
- la figure 3 représente schématiquement, en coupe, un deuxième mode de réalisation d'une semelle électrostatique conforme à la présente invention,
- la figure 4 représente, en coupe, la semelle électrostatique illustrée en figure 2, et
- la figure 5 représente, en perspective, la semelle électrostatique illustrée en figure 2.

Les éléments illustrés en figure 1 ont déjà été présentés plus haut.

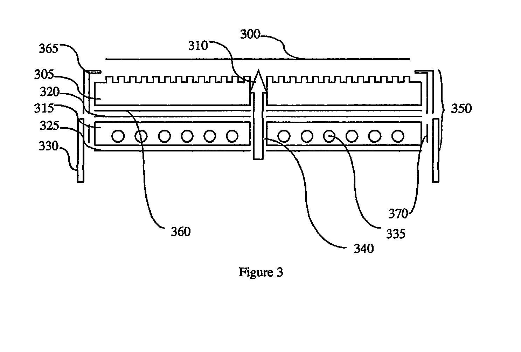

On observe, en figure 2, une semelle électrostatique 250 (en anglais "chuck") conforme à un mode de réalisation de la présente invention. On y observe un substrat 200 (en anglais "wafer") qui repose sur une céramique supérieure 205 de la semelle électrostatique 250, munie d'une ouverture centrale d'arrivée de gaz 210. La céramique supérieure 205 est collée, par une colle 260, à une céramique inférieure 215 qui porte des électrodes radiofréquence RF 220 et des éléments chauffants 225. La céramique inférieure 215 est, elle-même, assemblée de manière durable à un support 230 (ou piédestal) comportant des circuits de refroidissement 235. La céramique inférieure 215 possède une ouverture centrale d'arrivée de gaz 240, dans l'axe de l'ouverture centrale d'arrivée de gaz 210 de la céramique supérieure 205. Le piédestal 230 possède une ouverture centrale d'arrivée de gaz 245, dans l'axe des ouvertures centrales d'arrivée de gaz 210 et 240 des céramiques supérieure et inférieure.

Par ces ouvertures centrales d'arrivée de gaz 210, 240 et 245 est injecté un gaz 255, par exemple de l'hélium ou de l'argon, favorisant les échanges thermiques entre la céramique supérieure 205 et le substrat 200.

Ainsi, conformément à la présente invention, il n'y a plus qu'une seule séparation (en anglais "gap") entre le substrat 200 et chacun des composants de chauffage, de refroidissement ou de rayonnement, ce qui réduit les contraintes concernant la montée en température, le contrôle de la température (chaque séparation provoque une différence de température de 30 °C) et l'uniformité de température sur la surface du substrat 200.

La colle 260 est, dans un mode de réalisation particulièrement intéressant, une colle constituée de verre qui est appliquée à une température à laquelle le verre est liquide et malléable. Le collage assure ainsi une isolation électrique entre les deux céramiques. Les électrodes radiofréquence RF 220 sont, par exemple, des électrodes plates positionnées sur la face supérieure de la céramique inférieure 215. Les éléments chauffants 225 sont, par exemple, des électrodes plates positionnées sur la face inférieure de la céramique inférieure 215.

L'assemblage entre la céramique inférieure 215 et le piédestal 230 est, par exemple formé par liaison brasée mettant en oeuvre une brasure à l'indium 270 assurant une bonne liaison thermique. Selon une variante, l'assemblage entre la céramique inférieure 215 et le piédestal 230 est formé par collage, par exemple avec une colle à l'argent 270. Les pions 265 permettent la manipulation des tranches.

On observe, en figure 3, une semelle électrostatique 350 (en anglais "chuck") conforme à un mode de réalisation de la présente invention. On y observe un substrat 300 (en anglais "wafer") qui repose sur une céramique supérieure 305 de la semelle électrostatique 350, munie d'une ouverture centrale d'arrivée de gaz 310. La céramique supérieure 305 est collée, par une colle 360, à une céramique inférieure 315 qui porte des électrodes radiofréquence RF 320, des éléments chauffants 325 et des circuits de refroidissement 335. La céramique inférieure 315 est, elle-même, assemblée de manière durable, par ses faces latérales, à un support 330. La céramique inférieure 315 possède une ouverture centrale d'arrivée de gaz 340, dans l'axe de l'ouverture centrale d'arrivée de gaz 310 de la céramique supérieure 305.

Par ces ouvertures centrales d'arrivée de gaz 310 et 340 est injecté un gaz 350, par exemple de l'hélium ou de l'argon, favorisant les échanges thermiques entre la céramique supérieure 305 et le substrat 300.

Ainsi conformément à la présente invention, il n'y a plus qu'une seule séparation (en anglais "gap") entre le substrat 300 et chacun des composants de chauffage, de refroidissement ou de rayonnement, ce qui réduit les contraintes concernant la montée en température, le contrôle de la température et l'uniformité de température sur la surface du substrat 300.

La colle 360 est, dans un mode de réalisation particulièrement intéressant, une colle constituée de verre qui est appliquée à une température à laquelle le verre est liquide et malléable. Le collage assure ainsi une isolation électrique entre les deux céramiques. Les électrodes radiofréquence RF 320 sont, par exemple, des électrodes plates positionnées sur la face supérieure de la céramique inférieure 315. Les éléments chauffants 325 sont, par exemple, des électrodes plates positionnées sur la face inférieure de la céramique inférieure 315.

L'assemblage entre la céramique inférieure 315 et le support 330 est, par exemple formé par liaison brasée mettant en oeuvre une brasure à l'indium 370 assurant une bonne liaison thermique. Selon une variante, l'assemblage entre la céramique inférieure 315 et le support 330 est formé par collage, par exemple avec une colle à l'argent 370.

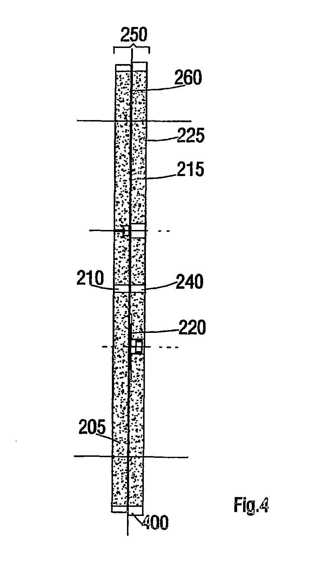

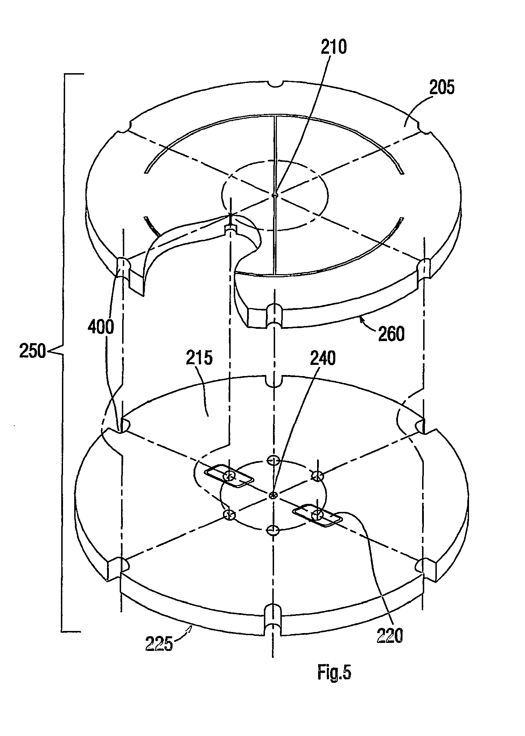

On observe, en figure 4, en coupe et en figure 5, en perspective, la semelle électrostatique illustrée en figure 2. En figure 5, les deux céramiques 205 et 215 sont séparées dans un but explicatif.

On observe, en figures 4 et 5, la semelle électrostatique 250 comportant la céramique supérieure 205 et la céramique inférieure 215, les ouvertures centrales 210 et 240, la couche de colle 260, les électrodes radiofréquence RF 220 et les éléments chauffants 225. Six évidements cylindriques latéraux 400 parallèles à l'axe des céramiques sont formés à intervalle régulier sur les céramiques, pour que s'y logent les pions 365 de manipulation des tranches.

## Revendications

1. - Semelle électrostatique (250, 350), **caractérisée en ce qu'**elle comporte :
- une céramique supérieure (205) adaptée à porter le substrat (200, 300) à traiter,
- une céramique inférieure (215, 315) portant des éléments chauffants (225, 325) et des électrodes radiofréquence (220, 320),
lesdites céramiques étant collées entre elles de manière durable.

2. - Semelle selon la revendication 1, **caractérisée en ce que** les céramiques (205, 215, 315) sont collées entre elles par du verre chauffé (260, 360).

3. - Semelle selon l'une quelconque des revendications 1 ou 2, **caractérisée en ce qu'**elle comporte un piédestal (230) portant des éléments de refroidissement (235), la céramique inférieure (215) étant assemblée au piédestal de manière durable.

4. - Semelle selon la revendication 3, **caractérisée en ce que** la céramique inférieure (215, 315) est assemblée au piédestal (230, 330) par liaison brasée (270, 370).

5. - Semelle selon la revendication 4, **caractérisée en ce que** la brasure de la liaison brasée (270, 370) est à l'indium.

6. - Semelle selon la revendication 3, **caractérisée en ce que** la céramique inférieure (215, 315) est assemblée au piédestal (230, 330) par collage.

7. - Semelle selon la revendication 6, **caractérisée en ce que** le collage (270, 370) de la céramique inférieure (215, 315) au piédestal (230, 330) est à l'argent.

8. - Semelle selon l'une quelconque des revendications 1 à 7, **caractérisée en ce que** la céramique inférieure (315) comporte des éléments de refroidissement (335).

9. - Semelle selon l'une quelconque des revendications 1 à 8, **caractérisée en ce que** la céramique inférieure (215, 315) est portée par des supports latéraux assemblés de manière durable à ladite céramique inférieure.

10. - Semelle selon l'une quelconque des revendications 1 à 9, **caractérisée en ce que** chacune des céramiques (205, 215, 315) supérieure et inférieure est traversée par une ouverture d'arrivée de gaz (210, 240, 245, 310, 340).

## Claims

1. An electrostatic chuck (250, 350), **characterised in that** it comprises:
- a top ceramic part (205) adapted to carry the substrate (200, 300) to be treated,
- a bottom ceramic part (215, 315) carrying heating elements (225, 325) and radio frequency electrodes (220, 320),
said ceramic parts being bonded together in a durable fashion.

2. A chuck according to claim 1, **characterised in that** the ceramic parts (205, 215, 315) are bonded together by heated glass (260, 360).

3. A chuck according to either one of claims 1 or 2, **characterised in that** it comprises a pedestal (230) carrying cooling elements (235), the bottom ceramic part (215) being connected to the pedestal in a durable fashion.

4. A chuck according to claim 3, **characterised in that** the bottom ceramic part (215, 315) is connected to the pedestal (230, 330) by brazed connection (270, 370).

5. A chuck according to claim 4, **characterised in that** the brazing solder of the brazed connection (270, 370) is of the indium type.

6. A chuck according to claim 3, **characterised in that** the bottom ceramic part (215, 315) is connected to the pedestal (230, 330) by adhesive bonding.

7. A chuck according to claim 6, **characterised in that** the adhesive bonding (270, 370) of the bottom ceramic part (215, 315) to the pedestal (230, 330) is of the silver type.

8. A chuck according to any one of claims 1 to 7, **characterised in that** the bottom ceramic part (315) comprises cooling elements (335).

9. A chuck according to any one of claims 1 to 8, **characterised in that** the bottom ceramic part (215, 315) is carried by lateral supports connected durably to said bottom ceramic part.

10. A chuck according to any one of claims 1 to 9, **characterised in that** each of the top and bottom ceramic parts (205, 215, 315) has a gas inlet opening (210, 240, 245, 310, 340) passing through it.

## Patentansprüche

1. Elektrostatische Bond-Einspannvorrichtung (250, 350), **dadurch gekennzeichnet, daß** sie aufweist:
- einen oberen Keramikkörper (205), der zum Halten des zu behandelnden Substrats (200, 300) eingerichtet ist,
- einen unteren Keramikkörper (215, 315), der Heizelemente (225, 325) und Hochfrequenzelektroden (220, 320) trägt,
wobei die genannten Keramikkörper miteinander dauerhaft verklebt sind.

2. Bond-Einspannvorrichtung nach Anspruch 1, **dadurch gekennzeichnet, daß** die Keramikkörper (205, 215, 315) miteinander durch erhitztes Glas (260, 360) verklebt sind.

3. Bond-Einspannvorrichtung nach einem der Ansprüche 1 oder 2, **dadurch gekennzeichnet, daß** sie einen Sockel (230) aufweist, der Kühlelemente (235) trägt, wobei der untere Keramikkörper (215) mit dem Sockel dauerhaft zusammengebaut ist.

4. Bond-Einspannvorrichtung nach Anspruch 3, **dadurch gekennzeichnet, daß** der untere Keramikkörper (215, 315) mit dem Sockel (230, 330) durch eine Lötverbindung (270, 370) verbunden ist.

5. Bond-Einspannvorrichtung nach Anspruch 4, **dadurch gekennzeichnet, daß** die Lötverbindung (270, 370) mit Indiumlot hergestellt ist.

6. Bond-Einspannvorrichtung nach Anspruch 3, **dadurch gekennzeichnet, daß** der untere Keramikkörper (215, 315) mit dem Sockel (230, 330) durch Kleben zusammengebaut ist.

7. Bond-Einspannvorrichtung nach Anspruch 6, **dadurch gekennzeichnet, daß** die Verklebung (270, 370) des unteren Keramikkörpers (215, 315) mit dem Sockel (230, 330) mit Silber hergestellt ist.

8. Bond-Einspannvorrichtung nach einem der Ansprüche 1 bis 7, **dadurch gekennzeichnet, daß** der untere Keramikkörper (315) Kühlelemente (335) aufweist.

9. Bond-Einspannvorrichtung nach einem der Ansprüche 1 bis 8, **dadurch gekennzeichnet, daß** der untere Keramikkörper (215, 315) von seitlichen Haltern getragen ist, die dauerhaft mit dem unteren Keramikkörper zusammengebaut sind.

10. Bond-Einspannvorrichtung nach einem der Ansprüche 1 bis 9, **dadurch gekennzeichnet, daß** jeder der oberen und unteren Keramikkörper (205, 215, 315) von einer Gaseintrittsöffnung (210, 240, 245, 310, 340) durchsetzt ist.
